Europäisches Patentamt

European Patent Office

Office européen des brevets

(19)

(11) EP 0 742 994 B1

(12) **EUROPÄISCHE PATENTSCHRIFT**

(45) Veröffentlichungstag und Bekanntmachung des Hinweises auf die Patenterteilung:
**08.07.1998 Patentblatt 1998/28**

(21) Anmeldenummer: **95906899.0**

(22) Anmeldetag: **01.02.1995**

(51) Int Cl.⁶: **H05H 1/46**

(86) Internationale Anmeldenummer:
**PCT/DE95/00131**

(87) Internationale Veröffentlichungsnummer:
**WO 95/21516 (10.08.1995 Gazette 1995/34)**

(54) **VORRICHTUNG ZUR PLASMAERZEUGUNG**

PLASMA-GENERATING DEVICE

DISPOSITIF GENERATEUR DE PLASMA

(84) Benannte Vertragsstaaten:
**AT BE CH DE FR GB IT LI NL**

(30) Priorität: **02.02.1994 DE 4403125**

(43) Veröffentlichungstag der Anmeldung:
**20.11.1996 Patentblatt 1996/47**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
- **BÄNZIGER, Ulrich**
  **D-13357 Berlin (DE)**
- **NEUMANN, Gerold**
  **D-10777 Berlin (DE)**
- **SCHEER, Hella-C.**
  **D-10717 Berlin (DE)**

(56) Entgegenhaltungen:
**EP-A- 0 403 418     EP-A- 0 489 407**
**EP-A- 0 641 014     WO-A-86/06923**

## Beschreibung

### Technisches Gebiet

Die Erfindung bezieht sich auf eine Vorrichtung zur Plasmaerzeugung durch induktive Einkopplung von Hochfrequenz (HF)-Energie für die plasmaunterstützte Bearbeitung von Substraten.

Plasmaprozesse kommen zunehmend bei der technischen Behandlung von Oberflächen bzw. oberflächennahen Schichten zum Einsatz. Dabei kann es sich um die Abscheidung von Schichten, die Härtung von Oberflächen, um Schichtabtrag oder um Reinigungsprozesse handeln.

Für die Erzeugung von Plasmen stehen unterschiedliche Methoden zur Verfügung, wie z. B. Elektron-Zyklotron-Resonanz oder rein kapazitive Energieeinkopplung. Im vorliegenden Fall erfolgt die Plasmaerzeugung durch induktive Einkopplung von HF-Energie über eine speziell geformte Antenne. Einen Überblick über diese Form der Plasmaerzeugung gibt z. B. J. Hopwood in Plasma Sources Sci. Technol. 1 (1992), 109 - 116.

### Stand der Technik

Das Problem der induktiven Einkopplung liegt darin, daß auf der Antenne aufgrund ihrer endlichen Induktivität elektrische Potentiale entstehen, die zu einem kapazitiven (E-Feld) Anteil der Anregung führen. Dieser kapazitive Anteil ist unerwünscht, da er zu hohen Plasmapotentialen führt, die die gezielte Substratbearbeitung störend beeinflussen.

Ein weiteres Problem stellt die Erzeugung gleichmäßiger Plasmen über große Flächen dar, etwa für die Bearbeitung von Flat-Panel-Displays. Durch Hochskalierung bereits existierender Plasmaquellen stößt man schnell an technische Grenzen. Die flächenhafte Anordnung von beliebig vielen Einzelquellen üblicher Größe hingegen erlaubt es, eine beliebig große Fläche ausreichend homogener Plasmadichte zu erhalten. Derartige Vorrichtungen sind z. B. in der US 4,713,585 oder der US 5,133,825 beschrieben. Als Einzelquelle eignen sich insbesondere kompakt aufgebaute oder bereits in sich flächenhaft angelegte Plasmaquellen.

In der US 5,122,251 ist eine Vorrichtung zur Plasmaerzeugung durch induktive Einkopplung von HF-Energie dargestellt, die aus einer zylinderförmigen, auf einer Seite offenen Plasmaproduktionskammer, einer Gaszuführung und einer Antenne besteht, die die Plasmaproduktionskammer in einer Ebene senkrecht zu ihrer Längsachse teilweise umschließt. Die Vorrichtung weist weiterhin um die Plasmaproduktionskammer angeordnete Mittel zur Erzeugung eines longitudinalen Magnetfeldes in der Kammer sowie eine Vorrichtung zur Anregung der Antenne mit HF-Energie auf. Die Antenne ist in Form einer offenen Schleife ausgebildet, wobei die Zuleitungen auf einer Seite der Plasmaproduktionskammer nebeneinander liegen. Durch die besonders einfache Form der Antenne wird ein kompakter Aufbau der Plasmaquelle ermöglicht.

Eine Weiterbildung der dargestellten Vorrichtung besteht darin, mehrere Plasmaproduktionskammern mit den zugehörigen Antennen nebeneinander anzuordnen, die in Serie geschaltet sind, mit einer gemeinsamen Anpassungsschaltung (Matchbox) verbunden sind und aus einem einzigen HF-Sender gespeist werden. Die plasmaunterstützte Bearbeitung größerer Flächen wird damit ermöglicht.

Die Vorrichtung weist jedoch den oben bechriebenen Nachteil auf, daß der durch die Induktivität der Antenne verursachte kapazitive Anteil der Plasmaanregung die gezielte Substratbearbeitung störend beeinflussen kann.

In der EP 0 641 014, einer nachveröffentlichten Patentanmeldung mit älterem Prioritätstag (zitiert aufgrund von R. 33.1(c) PCT), ist eine Vorrichtung zur Plasmaerzeugung bekannt, die den vorgenannten Nachteil nicht aufweist. Sie weist eine Antennenform auf, die aus einem einzigen kreisförmigen Ring besteht, dessen zwei diametral gegenüberliegende Punkte mit Einspeisungsleitungen verbunden sind. Die Vorrichtung ist jedoch als Einzelquelle ausgeführt, so daß damit noch keine großflächige Plasmabearbeitung möglich ist.

### Darstellung der Erfindung

Aufgabe der vorliegenden Erfindung ist es, eine Vorrichtung zur großflächigen Plasmabearbeitung anzugeben, die einen deutlich geringeren kapazitiven Anteil der Plasmaanregung aufweist, so daß eine gleichmäßige, stabile Plasmaanregung und Substratbearbeitung ermöglicht wird.

Die Aufgabe wird erfindungsgemäß mit der in Anspruch 1 angegebenen Vorrichtung gelöst. Besondere Ausführungsformen der Erfindung sind in den Unteransprüchen angegeben.

Die erfindungsgemäße Vorrichtung zeichnet sich neben den im Oberbegriff aufgeführten Merkmalen durch die besondere Ausgestaltung der Antenne aus. Die Antenne weist die Form eines in sich geschlossenen Ringes auf, der die Plasmaproduktionskammer in einer Ebene senkrecht zu ihrer Längsachse vollständig umschließt. Ein HF-Generator ist über eine Anpassungsschaltung mit den Antennen verbunden. Die Zuleitungen für den Antennenstrom sind an gegenüberliegenden Punkten an den jeweiligen Antennenringen angebracht. Damit wird erreicht, daß der Stromverlauf auf der Antenne symmetrisch erfolgt. Bei jeder Halbwelle der Spannung fließt der Strom auf beiden Ringhälften von einer Zuleitung ausgehend zur gegenüberliegenden Zuleitung. Dies entspricht einer Parallelschaltung zweier Induktivitäten (der ersten Ringhälfte und der zweiten Ringhälfte), so daß die Gesamtinduktivität der Antenne der Hälfte der Induktivität einer Ringhälfte entspricht.

Ein Vergleich dieser Induktivität mit der Antenneninduktivität aus der in der Beschreibungseinleitung gewürdigten US 5,122,251 zeigt den Vorteil der erfindungsgemäßen Vorrichtung. Bei der dortigen Antenne erfolgt der Stromfluß ausgehend von einer Zuleitung in der Schleife nahezu um die gesamte Plasmaproduktionskammer bis zur anderen Zuleitung. Dies entspricht einer Serienschaltung zweier Induktivitäten (der ersten Halbschleife und der zweiten Halbschleife), also einer Gesamtinduktivität in Höhe der doppelten Induktivität einer einzelnen Schleifenhälfte. Die Antenne der erfindungsgemäßen Vorrichtung weist demgegenüber nur etwa 1/4 dieser Induktivität auf, so daß geringere elektrische Potentiale auf der Antenne entstehen. Die erfindungsgemäße Vorrichtung zeichnet sich daher vorteilhafterweise durch einen deutlich geringeren kapazitiven Anteil der Plasmaanregung aus.

Bei der erfindungsgemäßen Vorrichtung sind mehrere Plasmaproduktionskammern als Einzelquellen nebeneinander angeordnet. Da die transversale Plasmadichteverteilung an der offenen Seite einer einzelnen Plasmaproduktionskammer leicht glockenförmig ausgebildet ist, ermöglicht die obige Anordnung bei geeignetem Abstand der Einzelquellen die Erzeugung einer homogenen Plasmadichteverteilung mit großer Flächenausdehnung. Die kompakte Bauart der Einzelquellen erweist sich dabei als Vorteil.
Jede Einzelquelle besteht aus einer Plasmaproduktionskammer mit Gaszuführung, einer Antenne und einer Vorrichtung zur Erzeugung eines longitudinalen Magnetfeldes in der Kammer sowie den Zuleitungen für die Antenne. Mehrere nebeneinander angeordnete Einzelquellen werden parallel aus einem gemeinsamen HF-Sender mit Anpassungsschaltung (Matchbox) gespeist. Dies ist im vorliegenden Fall einer rein induktiven Plasmaanregung unkritisch. Der Hochfrequenzstrom auf jeder einzelnen Antenne berechnet sich mit großer Genauigkeit gemäß $\underline{I} = \underline{U}/jwL$, wobei $\underline{U}$ die gemeinsame (komplexe) Antennenspannung, w die Kreisfrequenz und L die Antenneninduktivität einer Einzelquelle bezeichnen. Die Rückwirkung des Plasmas auf letztere ist unter der Voraussetzung einer kurzen Antenne sehr gering, so daß bei Beachtung eines symmetrischen Aufbaus (gleiche Antennenlängen bei allen Plasmaquellen) identische Antennenströme erhalten werden. Diese Ströme erzeugen das Plasma, indem sie entsprechende Wirbelströme in Form von bewegten Plasmaelektronen hervorrufen. Eine gleichmäßige, stabile Plasmaanregung durch mehrere parallel geschaltete Einzelquellen ist somit sichergestellt.
Im Gegensatz dazu hat eine Serienschaltung der Einzelquellen, wie sie in der weiter oben gewürdigten US 5,122,251 verwirklicht wurde, den Nachteil, daß zum einen die einzelnen Antennenströme nicht gleich groß sind, und daß zum anderen unterschiedliche Potentiale auf den einzelnen Antennen auftreten, die eine unterschiedliche kapazitive Einkopplung in das Plasma bewirken.
Bei einer besonderen Ausführungsform der erfindungsgemäßen Vorrichtung sind die Einzelquellen vorzugweise derart beabstandet, daß das Verhältnis von Abstand zum Innendurchmesser der Plasmaproduktionskammern bei einem Wert zwischen 1,5 und 3 liegt (Anspruch 5).

Die erfindungsgemäße Vorrichtung wird nachfolgend anhand eines Ausführungsbeispiels und der Zeichnungen näher erläutert.

Dabei zeigen:

Figur 1:     Einen Längsschnitt durch eine bevorzugte Ausführungsform einer Einzelquelle der erfindungsgemäßen Vorrichtung,

Figur 2:     schematisch die Antennenform und -anordnung der Einzelquelle, und

Figur 3:     schematisch die erfindungsgemäße Vorrichtung.

## Ausführungsbeispiel

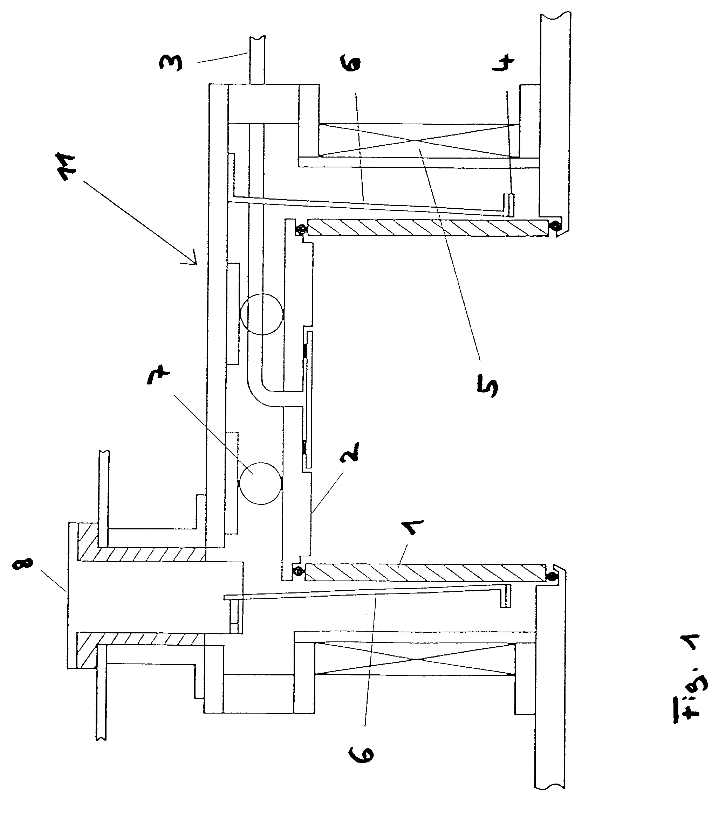

Ein Beispiel für eine Einzelquelle der erfindungsgemäßen Vorrichtung nach Anspruch 1 ist in Figur 1 im Längsschnitt dargestellt. Die Plasmaproduktionskammer dieser Einzelquelle wird durch den Quarzzylinder 1 gebildet, der am oberen Ende durch einen über Andruckfedern 7 geerdeten Deckelflansch 2 gasdicht abgeschlossen ist. An das untere, offene Ende des Quarzzylinders schließt sich eine Prozeßkammer an (in Figur 1 nicht dargestellt), in der die Substratbearbeitung erfolgt. Die Gaszuführung 3 ist in den Deckelflansch 2 integriert. Der Quarzzylinder wird an seinem unteren Ende von der ringförmigen Antenne 4 umschlossen, deren Zuleitungen 6 annähernd parallel zur Längsachse des Quarzzylinders verlaufen und mit einem Matchbox-Anschluß 8 verbunden sind. Die Zuleitungen können selbstverständlich auch unter einem beliebigen anderen Winkel zur Längsachse der Plasmaproduktionskammer verlaufen. Die zugehörige Matchbox (in Form einer Anpassungsschaltung) und der HF-Generator sind in der Figur nicht dargestellt. Quarzzylinder und Antenne (mit Zuleitungen) werden von einer Magnetfeldspule 5 umschlossen die ein longitudinales Magnetfeld in der Plasmaproduktionskammer erzeugt.
Der Spulenkörper der Magnetfeldspule 5 dient außerdem als Abschirmung gegen von der Antenne in den Außenraum abgestrahlte Hochfrequenzfelder, so daß insgesamt ein sehr kompakter Aufbau, sowohl was die Bauhöhe (aufgrund der einfachen Antennenform) als auch den Außendurchmesser (keine zusätzliche Abschirmung) der Quelle betrifft, erreicht wird. Die Antennenform erlaubt zudem den Betrieb der Quelle bei niedrigen Spulenfeldern, so daß die Magnetspule sehr kompakt gehalten werden kann.

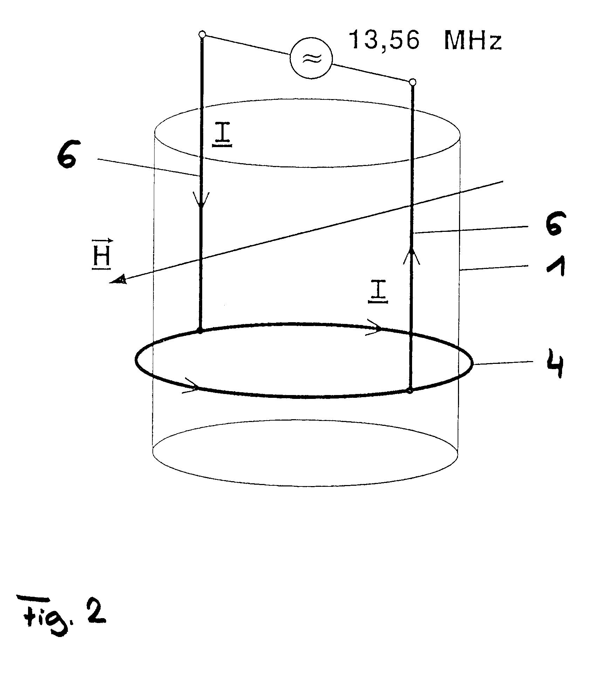

Die Antenne 4 ist in Figur 2 schematisch dargestellt. Der Quarzzylinder 1 der Plasmaproduktionskammer wird von der Antenne ringförmig umschlossen. Die Zuleitungen 6 sind an gegenüberliegenden Punkten auf dem Antennenring mit diesem verbunden. Das anregende Hochfrequenzmagnetfeld $\vec{H}$ weist in transversaler Richtung (senkrecht zur Längsachse des Zylinders, vgl. Figur 2), so daß diese Antennenform die Anregung des m =1 Mode einer elektromagnetischen Welle, der sog. Whistler-Welle, ermöglicht. Die Antenne wird vorzugsweise mit einer Frequenz von 13,56 MHz aus einem Hochfrequenzgenerator mit zugehöriger Anpassungsschaltung gespeist. Bei jeder Halbwelle der Antennenspannung erfolgt der Stromverlauf $\underline{I}$ ausgehend von einer Zuleitung symmetrisch auf beiden Ringhälften zur zweiten Zuleitung, wie Figur 2 zu entnehmen ist. Aufgrund der damit verbundenen geringen Induktivität der Antenne von ca. 0,1 µH (Länge des Quarzzylinders 10 cm, Außendurchmesser des Quarzzylinders 15 cm) entstehen auf der Antenne nur sehr geringe elektrische Potentiale, so daß der daraus resultierende kapazitive (E-Feld) Anteil der Anregung gegenüber dem induktiven (H-Feld) vernachlässigt werden kann. Auf eine elektrostatische Schirmung zwischen Quarzzylinder und Antenne kann somit verzichtet werden.

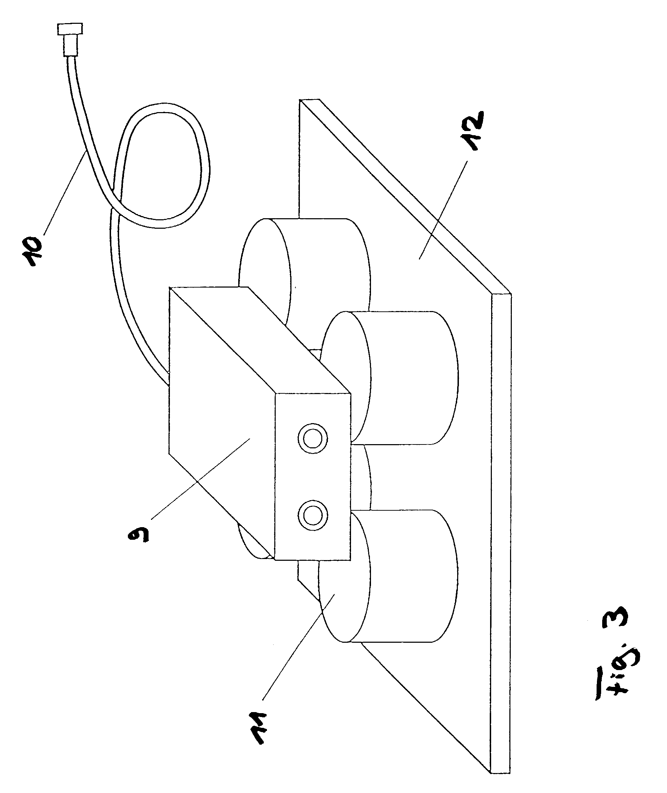

Figur 3 zeigt schematisch eine Vorrichtung zur großflächigen Plasmaerzeugung, die aus vier Einzelquellen 11 gemäß Figur 1 zusammengesetzt ist. Die vier Einzelquellen 11 werden aus einem einzigen HF-Generator (in der Abbildung ist der HF-Generator-Anschluß 10 dargestellt) mit zugehöriger Anpassungsschaltung (Matchbox 9) parallel gespeist. Die in möglichst geringem Abstand nebeneinander angeordneten Einzelquellen sind an ihrer offenen Unterseite mit einer gemeinsamen Prozeßkammer zur Substratbearbeitung verbunden, von der in der Figur nur die Deckplatte 12 abgebildet ist. Mit der dargestellten Vorrichtung ist die Erzeugung großflächiger homogener Plasmen zur Bearbeitung großer Substratflächen möglich.

**Patentansprüche**

1. Vorrichtung zur Plasmaerzeugung durch induktive Einkopplung von HF-Energie für die plasmaunterstützte Bearbeitung von Substraten, bei der mehrere Plasmaproduktionskammern (1, 2), die jeweils eine Gaszuführung (3), eine Antenne (4) mit zwei Zuleitungen (6) und eine Vorrichtung (5) zur Erzeugung eines longitudinalen Magnetfeldes in der Kammer aufweisen, nebeneinander angeordnet sind,
   **dadurch gekennzeichnet,**
   daß jede Antenne (4) aus einem einzigen in sich geschlossenen Ring besteht, der die Plasmaproduktionskammer in einer Ebene senkrecht zu ihrer Längsachse umschließt, wobei die Zuleitungen (6) der Antenne an sich gegenüberliegenden Punkten des Ringes mit dieser verbunden sind, und die Antennen parallel aus einem einzigen HF-Sender mit Anpassungsschaltung gespeist werden.

2. Vorrichtung nach Anspruch 1,
   **dadurch gekennzeichnet,**
   daß die Vorrichtung (5) zur Erzeugung eines longitudinalen Magnetfeldes in der Kammer eine elektromagnetische Spule ist, die Plasmaproduktionskammer und Antenne umschließt.

3. Vorrichtung nach Anspruch 1 oder 2,
   **dadurch gekennzeichnet,**
   daß die Zuleitungen (6) der Antenne (4) annähernd parallel zur Längsachse der Plasmaproduktionskammer verlaufen.

4. Vorrichtung nach Anspruch 3,
   **dadurch gekennzeichnet,**
   daß die Plasmaproduktionskammer aus einem nach beiden Seiten offenen Quarzzylinder (1) besteht, der auf einer Seite durch einen Deckelflansch (2) mit integrierter Gaszuführung (3) gasdicht abschließbar ist, der Quarzzylinder im Bereich der dem Deckelflansch gegenüberliegenden offenen Seite von der Antenne (4) umschlossen ist, und sich die elektromagnetische Spule (5) über mehr als 80 % der Länge des Quarzzylinders erstreckt.

5. Vorrichtung nach einem der Ansprüche 1 bis 4,
   **dadurch gekennzeichnet,**
   daß die Plasmaproduktionskammern so nebeneinander angeordnet sind, daß das Verhältnis von Abstand zu Innendurchmesser der Plasmaproduktionskammern bei einem Wert zwischen 1,5 und 3 liegt.

**Claims**

1. Device for producing plasma by inductive coupling of HF-energy for the plasma-supported processing of substrates, in which device a plurality of plasma production chambers (1,2), which each have a gas supply (3), an antenna (4) with two supply lines (6) and a device (5) for generating a longitudinal magnetic field in the chamber, are arranged beside one another,
   **characterised in that**
   each antenna (4) comprises a single enclosed ring which surrounds the plasma production chamber in a plane perpendicular to its longitudinal axis, the supply lines (6) of the antenna being connected to said antenna at opposite points of the ring, and the antennae being fed in parallel from a single HF-transmitter with matching circuit.

2. Device according to claim 1,
   **characterised in that**
   the device (5) for generating a longitudinal magnetic field in the chamber is an electromagnetic coil which surrounds production chamber and antenna.

**3.** Device according to claim 1 or 2,
**characterised in that**
the supply lines (6) of the antenna (4) run approximately parallel to the longitudinal axis of the plasma production chamber.

**4.** Device according to claim 3,
**characterised in that**
the plasma production chamber consists of a quartz cylinder (1) open at both ends and which may be sealed gas-tight at one side by a cover flange (2) with integrated gas supply (3), in that the quartz cylinder is enclosed by the antenna (4) in the region of its open side opposite the cover flange, and in that the electromagnetic coil (5) extends over more than 80% of the length of the quartz cylinder.

**5.** Device according to one of claims 1 to 4,
**characterised in that**
the plasma production chambers are arranged beside one another in such a way that the ratio of the spacing to the inner diameter of the plasma production chambers has an approximate value of between 1.5 and 3.

## Revendications

**1.** Dispositif de production de plasma par couplage inductif d'énergie HF pour le traitement appuyé par du plasma de substrats, dans lequel plusieurs chambres de production de plasma (1, 2) qui comportent respectivement une ligne d'amenée de gaz (3), une antenne (4) avec deux lignes électriques (6) et un dispositif (5) pour créer un champ magnétique longitudinal dans les chambres, sont disposées les unes près des autres,
caractérisé en ce que
chaque antenne (4) se compose d'un seul anneau fermé, qui entoure la chambre de production de plasma dans un plan perpendiculaire à son axe longitudinal, les lignes (6) de l'antenne étant reliées à l'antenne en des points opposés de l'anneau et les antennes étant alimentées en parallèle à partir d'un émetteur HF unique avec un circuit d'adaptation.

**2.** Dispositif selon la revendication 1,
caractérisé en ce que
le dispositif (5) pour la production d'un champ magnétique longitudinal dans la chambre est une bobine électromagnétique, qui entoure la chambre de production du plasma et l'antenne.

**3.** Dispositif selon la revendication 1 ou 2,
caractérisé en ce que
les lignes (6) de l'antenne (4) se développent approximativement parallèlement à l'axe longitudinal de la chambre de production du plasma.

**4.** Dispositif selon la revendication 3,
caractérisé en ce que
la chambre de production du plasma se compose d'un cylindre de quartz (1), qui peut être fermé sur une face de manière étanche aux gaz par une bride d'obturation (2) ayant une conduite d'alimentation de gaz intégrée (3), le cylindre de quartz est entouré dans la zone de la face ouverte opposée à la bride d'obturation par l'antenne (4), et la bobine électrique magnétique (5) s'étend sur plus de 80 % de la longueur du cylindre de quartz.

**5.** Dispositif selon une des revendications 1 à 4,
caractérisé en ce que
les chambres de production de plasma sont disposées les unes près des autres, de façon que le rapport de l'écartement ou diamètre intérieur des chambres de production de plasma se situe à une valeur entre 1,5 et 3.

Fig. 1

13,56 MHz

Fig. 2

EP 0 742 994 B1

10

12

9

11

Fig. 3